# EUROPÄISCHE PATENTSCHRIFT

(11) **EP 3 111 476 B1**
(45) Veröffentlichungstag und Bekanntmachung des Hinweises auf die Patenterteilung: **04.04.2018**
(21) Anmeldenummer: 15706201.9
(22) Anmeldetag: 17.02.2015
(51) Int. Cl.: H01L 25/07, H01L 23/051, H01L 23/473, H01L 23/48

(54) **VERBESSERTE SCHEIBENZELLE FÜR MEHRERE DRUCKKONTAKTIERTE HALBLEITERBAUELEMENTE**
IMPROVED DISC-SHAPED CASING FOR A PLURALITY OF PRESSURE-CONTACTED SEMICONDUCTOR COMPONENTS
BOÎTIER CIRCULAIRE AMÉLIORÉ POUR UNE PLURALITÉ DE COMPOSANTS SEMI-CONDUCTEURS À CONTACT PAR PRESSION

(30) Priorität: 26.02.2014 DE 102014102493
(43) Veröffentlichungstag der Anmeldung: 04.01.2017
(73) Patentinhaber: Infineon Technologies Bipolar GmbH & Co. KG, 59581 Warstein (DE); Siemens Aktiengesellschaft, 80333 München (DE)
(72) Erfinder: SCHENK, Mario, 59581 Warstein (DE); PRZYBILLA, Jens, 59581 Warstein (DE); BARTHELMESS, Reiner, 59494 Soest (DE); DORN, Jörg, 96155 Buttenheim (DE)
(74) Vertreter: Lohmanns, Bernard
(86) Internationale Anmeldenummer: PCT/EP2015/053289
(87) Internationale Veröffentlichungsnummer: WO 2015/128220

(56) Entgegenhaltungen:
- EP-A1- 0 962 973
- EP-A2- 2 211 384
- DE-A1- 3 223 532

## Beschreibung

Die vorliegende Erfindung betrifft eine Scheibenzelle für mehrere Halbleiterbauelemente, insbesondere mehrere Leistungshalbleiterbauelemente. Im Allgemeinen dienen solche Scheibenzellen der Aufnahme und elektrischen Kontaktierung wenigstens eines Halbleiterbauelements und stehen in der Regel in wärmeleitendem Kontakt mit einem Kühlkörper. Wesentlicher Sinn dieser Scheibenzelle ist der hermetische Verschluss des Halbleiterbauelements bei gleichzeitiger elektrischer und thermischer Verbindung durch Druckkontaktierung des Halbleiterbauelements von außen. Die bekannte Scheibenzelle umfasst im Wesentlichen ein Gehäuse und wenigstens ein Halbleiterbauelement. Die Scheibenzelle stellt dabei eine handelbare Einheit dar. Darüber hinaus sind Scheibenzellen bekannt, in der mehrere Halbleiterbauelemente, die bezüglicher ihrer geometrischen Abmessungen die gleiche Bauart aufweisen, aufgenommen sind. Dies ist insoweit unproblematisch, da bei übereinstimmender Bauart die Bauelemente bezüglich ihrer mechanischen Belastungsgrenzen identisch sind. Problematisch wird das Einspannen mehrerer Bauelemente dann, wenn diese beispielsweise schon aufgrund unterschiedlicher Geometrie mechanisch unterschiedlich belastbar sind. Während die reine Bestückung des Gehäuseinneren mit den Halbleiterbauelementen in der Regel unproblematisch ist, kann das mechanisch schwächste Bauelement beim Einspannen leicht Schaden nehmen, wenn die Scheibenzelle in der Regel beim Endabnehmer zur elektrischen und thermischen Kontaktierung eingespannt wird. Aufgrund der unterschiedlichen Belastungsgrenzen mussten daher bisher die Halbleiterbauelemente unterschiedlicher Bauart in separaten Scheibenzellen eingespannt werden, um die Einspannung für jedes Bauelement separat einstellen zu können, um damit letztlich den unterschiedlichen mechanischen Belastungsgrenzen der Bauelemente Rechnung tragen zu können. Dies hat den Nachteil, dass die Anzahl der Bauteile erhöht ist, das Bauvolumen der Scheibenzelle nachteilig groß ausfällt und die Konstruktion und/ oder die gegebenenfalls notwendige spezifische Einstellung der Einspannung vergleichsweise aufwändig ist.

Gattungsgemäße, die Scheibenzelle umfassende Anordnungen weisen dazu Einspannmittel, wie Zug- oder Druckverschraubungen, auf, die der Festlegung der Halbleiterbauelemente und der elektrischen sowie thermischen Druckkontaktierung der erfindungsgemäß mehreren Halbleiterbauelemente dienen. Im Hinblick auf die gerade in der Leistungshalbleiterelektronik auftretenden Probleme bei thermischen Wechsellasten wurden zur Kontaktierung hochspannungsfester und hochstromfester Bauelemente derartige Druckkontakte entwickelt. Beispiele für solche hochspannungsfesten Halbleiterbauelemente sind Hochvolt-Thyristoren, die die zentralen Bauelemente in Hochleistungsumrichtern. Insbesondere für solche Anlagen gelten hohe Anforderungen an die Bauelemente-Zuverlässigkeit. Da die Bauelemente vergleichsweise spröde Schichten aus Halbleitermaterial aufweisen, sind die Bauelemente immer der Gefahr ausgesetzt, bei mechanischer Überbeanspruchung durch die Druckkontaktierung zerstört zu werden.

Dabei erfolgt auch die Herstellung und Aufrechterhaltung eines mechanischen und somit elektrischen und thermischen Kontakts zwischen einem Kontaktbereich eines elektronischen Bauelements und einem den Strom führenden Kontakt im Wesentlichen durch die mechanisch aufgebrachten Kräfte. Dies hat den Vorteil, dass durch eine entsprechende Einstellung der mechanischen Kräfte - zum Beispiel über Spannvorrichtungen oder über Federeinrichtungen - den thermischen Wechsellasten wegen der mit dieser mechanischen Fixierung verbundenen mechanischen Toleranzen ausreichend Rechnung getragen werden kann. Die EP 0 962 973 A1 und die EP 2 211 384 A2 offenbaren jeweils Scheibenzellen zur Druckkontaktierung mehrerer Halbleiterbauelemente mit Druckplatten und einem Einspannmittel. Vor dem Hintergrund dieser Nachteile hat sich die vorliegende Erfindung die Aufgabe gestellt, eine Scheibenzelle für mehrere Halbleiterbauelemente sowie eine Anordnung aus dieser mit Einspannmitteln bereitzustellen, bei der eine hohe Integrationsdichte trotz unterschiedlicher Halbleiterbauelemente erreicht ist, die Anzahl der Bauteile aber auch die Anzahl der benötigten Scheibenzellen verringert ist, das Bauvolumen verringert ist, die Einstellung der Einspannung vereinfacht und/oder den unterschiedlichen mechanischen Belastungsgrenzen der Bauelemente besser Rechnung getragen werden kann. Diese Aufgabe wird erfindungsgemäß durch eine Scheibenzelle mit den Merkmalen nach Anspruch 1 gelöst. Weitere, besonders vorteilhafte Ausgestaltungen der Erfindung offenbaren die Unteransprüche. Es ist darauf hinzuweisen, dass die in den Patentansprüchen einzeln aufgeführten Merkmale in beliebiger, technisch sinnvoller Weise miteinander kombiniert werden können und weitere Ausgestaltungen der Erfindung aufzeigen. Die Beschreibung charakterisiert und spezifiziert die Erfindung insbesondere im Zusammenhang mit den Figuren zusätzlich.

Die Erfindung betrifft eine Scheibenzelle für mehrere Halbleiterbauelemente wie im Anspruch 1 beschrieben. Die erfindungsgemäße Scheibenzelle umfasst ein Gehäuse. Das Gehäuse weist bevorzugt eine Wandung aus einem elektrisch nichtleitenden Material, wie Keramik, auf. Die Wandung ist beispielsweise ringförmig. Bevorzugt sind die Halbleiterbauelemente hermetisch umschlossen in dem Gehäuseinneren aufgenommen. Ferner umfasst die Scheibenzelle wenigstens ein erstes im Gehäuse aufgenommenes Halbleiterbauelement erster Bauart und wenigstens ein zweites im Gehäuse aufgenommenes Halbleiterbauelement zweiter Bauart. Der Begriff "Scheibenzelle" definiert somit eine Einheit aus einem Gehäuse und mehreren Halbleiterbauelementen, die im Folgenden auch kurz als "Bauelemente" bezeichnet werden. Bevorzugt sind die Bauelemente unverlierbar in dem Gehäuse aufgenommen, auch wenn die Scheibenzelle nicht eingespannt und/oder an einem Kühlkörper befestigt ist. Die Terminologie "unterschiedliche Bauart" ist weit auszulegen, und meint beispielsweise unterschiedliche Außenabmessungen und/oder Geometrien, aber auch einen Unterschied im Schichtaufbau, bei ansonsten identischer Außenabmessungen, kann aber auch einen unterschiedliche Kontaktkraft bei der Druckkontaktierung beinhalten. Bevorzugt handelt es sich wenigstens um einen Unterschied in der mechanischen Belastungsgrenze der verschiedenen Bauarten parallel zur Richtung der Einspannung.

Erfindungsgemäß umfasst das Gehäuse wenigstens eine das erste und zweite Halbleiterbauelement übergreifende, im Wesentlichen rechtwinklig zur Einspannkraft ausgerichtete, metallische Druckplatte zur Einspannung des ersten und zweiten Halbleiterbauelements. Dabei ist die Druckplatte so ausgestaltet, dass die Einspannkraft lokal begrenzt auf diese einwirkt, um über die Druckplatte das erste und zweite Halbleiterbauelement einzuspannen, wobei das erste Halbleiterbauelement unterhalb des lokalen Einwirkbereichs der Einspannkraft angeordnet ist und das zweite Bauelement wenigstens teilweise, d.h. teilweise bis vollständig, bevorzugt vollständig, außerhalb des lokalen Einwirkbereichs angeordnet ist.

Die Erfindung betrifft ferner eine Anordnung aus der zuvor beschriebenen Scheibenzelle und Einspannmitteln, die vorgesehen sind, um das erste und zweite Halbleiterbauelement unter Einwirkung einer von den Einspannmitteln erzeugten Einspannkraft einzuspannen und um das erste und zweite Halbleiterbauelement elektrisch zu kontaktieren. Die Einspannkraft wird beispielsweise durch Federn oder Schraubmittel, bevorzugt durch eine Zug- oder Druckverschraubung erzeugt.

In einer Ausgestaltung werden die Bauelemente erster und zweiter Bauart zwischen einer zuvor beschriebenen Druckplatte und einer druckaufnehmenden Gegenplatte eingespannt, wobei die Gegenplatte beispielsweise vollflächig an einem Kühlkörper anliegt. Gemäß einer bevorzugten Ausgestaltung werden die Bauelemente erster und zweiter Bauart zwischen zwei erfindungsgemäß ausgestalteten Druckplatten eingespannt. Bevorzugt sind die Druckplatte und die Gegenplatte so ausgestaltet beziehungsweise sind Höhenausgleichscheiben vorgesehen, dass bei dem dem Einspannen zeitlich vorgeschalteten Annähern von Gegenplatte und Druckplatte der Berührkontakt zu dem ersten Halbleiterbauelement und dem zweiten Halbleiterbauelement zeitgleich erfolgt.

Anders ausgedrückt sorgt der Überstand der Druckplatte über den Einwirkbereich hinaus für eine Aufspaltung des Kraftverlaufs. Während das erste Halbleiterbauelement im Kraftverlauf der Einspannkraft angeordnet ist, sitzt das zweite unter dem überstehenden Teil der Druckplatte angeordnete Halbleiterbauelement im über die Druckplatte abgezweigten Kraftverlauf. Die metallische, bevorzugt runde Druckplatte wirkt somit als elastischer Biegebalken und federt die Einwirkung auf das oder die zweiten Halbleiterbauelemente ab. Die Anpresskraft und somit auch die mechanische Beanspruchung des oder der zweiten Halbleiterbauelemente ist somit gegenüber dem oder den ersten Halbleiterbauelementen reduziert. Dies kann beispielsweise dazu genutzt werden, dasjenige Halbleiterbauelement, das eine weniger kritische Abhängigkeit des Kontaktwiderstandes von der Einspannkraft aufweist, als zweites Halbleiterbauelement in dem abgezweigten Kraftverlauf anzuordnen. Bevorzugt weist das zweite Halbleiterbauelement eine Bauart auf, deren mechanische Belastungsgrenze in der Richtung der Einspannung geringer ist, als die entsprechende des ersten Halbleiterbauelements. Dieses befindet sich erfindungsgemäß im Bereich des abgezweigten Kraftverlaufs. Beispielsweise ergibt sich die unterschiedliche Belastungsgrenze zwischen erstem und zweitem Bauelement durch eine unterschiedliche Dicke der in der Regel rechtwinklig zur Einspannkraft orientierten Halbleiterschicht. Durch die erfindungsgemäße Auslegung der Scheibenzelle wird selbst bei maximaler Einspannung des ersten Bauelements eine "abgefederte" Beanspruchung des zweiten Bauelements sichergestellt und es kann so trotz Maximalbeanspruchung durch die Einspannkraft des ersten Bauelements eine geringere Beanspruchung des zweiten Bauelements sichergestellt werden. Somit ist es möglich, mechanisch weniger belastbare Bauelemente mit höher belastbaren Bauelementen in einer Scheibenzelle zu paaren. Insbesondere ist es bei entsprechender Anordnung, nämlich wenn das zweite Bauelement das mechanisch gleich oder geringer belastbare Bauelement ist, sicher möglich, das erste Bauelement ohne die Gefahr der mechanischen Zerstörung des zweiten Bauelements einzuspannen. Somit kann auch bei maximal Belastung des ersten Bauelements, welche aus Gründen der thermischen und elektrischen Kontaktierung angestrebt wird, eine Zerstörung der zweiten Halbleiterbauelemente sicher verhindert werden.

Bevorzugt liegt die Druckplatte an den entsprechenden Kontaktierungsflächen der Halbleiterbauelemente an und dient damit gleichzeitig der unmittelbaren elektrischen und thermischen Kontaktierung der Halbleiterbauelemente.

Gemäß einer weiteren Ausgestaltung ist vorgesehen, dass das erste Halbleiterbauelement wenigstens mit einer seiner Anlageflächen wenigstens im nicht eingespannten Zustand nicht vollflächig aufliegt. Anders ausgedrückt, es bildet das Halbleiterbauelement mit seinem anliegenden Gegenpart, beispielsweise der erfindungsgemäßen Druckplatte oder der druckaufnehmenden Gegenplatte einen Hohlraum aus. Dadurch besteht die Möglichkeit, dass das erste Halbleiterbauelement unter Wirkung der Einspannung einer Formänderung unterliegt und die Anlage des Halbleiterbauelements sich durch elastische oder plastische Verformung des Bauelements mit zunehmender Einspannkraft vergrößert. Somit "federt" das Halbleiterbauelement die Einspannung ab. Damit kann die Einspannung des zweiten Halbleiterbauelements aufgrund der Gegenkraft des ersten Halbleiterbauelements besser eingestellt werden. Bevorzugt wird dies durch eine gekrümmte Anlagefläche auf Seiten des Halbleiterbauelements gelöst. Beispielsweise weist eine äußere, aus Halbleitermaterial, beispielsweise Silizium, bestehende Schicht des ersten Halbleiterbauelements eine Oberfläche auf, die weg von der Anlagefläche gekrümmt ist.

Gemäß einer weiteren Ausgestaltung ist das erste Halbleiterbauelement, also beispielsweise der gesamte Schichtaufbau im nicht eingespannten Zustand gekrümmt ausgebildet.

Gemäß einer weiteren Ausgestaltung besteht der maximale lichte Abstand zwischen der Anlagefläche und der zugehörigen Gegenfläche im nicht eingespannten Zustand in einem Bereich von 5 µm bis 150µm, bevorzugt 10µm bis 100µm liegt. Der Begriff lichte Abstand meint den maximal möglichen Höhenunterschied zwischen vollflächigem Anliegen und unbelastetem Anliegen.

Gemäß einer bevorzugten Ausgestaltung liegt der Außenumfang des ersten Halbleiterbauelements außerhalb des Einwirkbereichs der Einspannkraft oder ist deckungsgleich mit dem Außenumfang des Einwirkbereichs. In Kombination mit einem lediglich am Außenumfang aufliegenden und im inneren Bereich der Anlagefläche im nicht eingespannten Zustand überhöhten, ersten Halbleiterbauelement, wird so bei tellerförmigen Halbleiterbauelemente eine hohe Nachgiebigkeit des ersten Halbleiterbauelements erreicht.

Gemäß einer bevorzugten Ausgestaltung der erfindungsgemäßen Scheibenzelle ist genau ein erstes Halbleiterbauelement vorgesehen, während mehrere zweite Halbleiterbauelemente vorgesehen sind und die zweiten Halbleiterbauelemente in übereinstimmendem Abstand oder in verschiedenen Abständen, wobei ein jeweils unterschiedlicher Abstand mit umfasst sein soll, um das erste Halbleiterbauelement verteilt angeordnet sind. Mit dieser Ausgestaltung lässt sich die Integrationsdichte erhöhen, ohne auf die eingangs genannten Vorzüge, wie die mechanische Belastungsabstufung in radialer Richtung, verzichten zu müssen. Bevorzugt erfasst der lokale Einwirkbereich der Druckplatte dessen geometrischen Mittelpunkt.

Bevorzugt ist das erste Halbleiterbauelement als kreisrundes Flächengebilde ausgebildet und es sind mehrere zweite Halbleiterbauelemente vorgesehen, die gleichmäßig entlang eines oder mehrerer konzentrischer Kreise um den Radialumfang des ersten Halbleiterbauelements verteilt angeordnet sind.

Gemäß einer bevorzugten Ausgestaltung sind fluidleitende Kanäle in die Druckplatte integriert, um die Druckplatte zur aktiven Kühlung mit einem Kühlmedium durchströmen zu können.

Das erste Halbleiterbauelement ist beispielsweise als ein rundes Flächengebilde ausgestaltet. Beispielsweise weist es einen Durchmesser im Bereich von 10 bis 100 mm, bevorzugt im Bereich von 20 bis 80 mm, noch bevorzugter im Bereich von 50 bis 70 mm, wie 60 mm auf. Die in einer Ausgestaltung vorgesehenen zweiten, um das erste Halbleiterbauelement angeordneten Halbleiterbauelemente sind beispielsweise in einem Ring um das erste Halbleiterbauelement angeordnet, dessen Innen-/Außendurchmesser im Bereich von 10/20 bis 100/200 mm, bevorzugt im Bereich von 20/40 bis 80/160 mm, noch bevorzugter im Bereich von 50/100 bis 70/140 mm, wie 60/120 mm liegt.

Gemäß einer weiteren Ausgestaltung stehen die für die elektrische Kontaktierung vorgesehenen Maximalflächen, auch aktive Fläche genannt, in einem bestimmten Verhältnis. Unter anderem zur Erreichung einer hohen Flächenbelegungsdichte liegt das Verhältnis der aktiven Fläche des ersten Bauelements zu der des zweiten Bauelements in einem Bereich von 1:1 bis 1:4, noch bevorzugter im Bereich von 1:1,5 bis 1:2,5, und beträgt beispielsweise 1:2. Für eine besonders hohe Flächenbelegungsdichte und damit Integrationsdichte der erfindungsgemäßen Scheibenzelle ist das wenigstens eine, zweite Halbleiterbauelement als rechteckiges, bevorzugt quadratisches, oder trapezförmiges Flächengebilde ausgebildet.

Bevorzugt ist das erste Halbleiterbauelement ein monolithisches Halbleiterbauelement, wie eine Diode oder Thyristor.

Bevorzugt ist das wenigstens eine zweite Halbleiterbauelement ein Bipolartransistor mit isolierter Gate-Elektrode (IGBT).

Bevorzugt sind die Halbleiterbauelemente erster und zweiter Bauart untereinander in der zur Einspannkraft rechtwinkligen Richtung zueinander beabstandet angeordnet, beispielsweise beträgt der Abstand 2 mm bis 10 mm.

Die Erfindung betrifft ferner eine Anordnung aus einem Kühlkörper und einer Scheibenzelle in einer der zuvor beschriebenen Ausführungsformen und mit den entsprechenden zuvor erwähnten technischen Vorzügen.

Die Erfindung wird anhand der nachfolgenden Figuren näher erläutert. Die Figuren sind dabei nur beispielhaft zu verstehen und stellen lediglich eine bevorzugte Ausführungsvariante dar. Es zeigen:
- Fig.1: eine Schnittansicht einer ersten Ausführungsform einer erfindungsgemäßen Anordnung aus der Scheibenzelle und Einspannmitteln;
- Fig.2: eine Schnittansicht einer zweiten Ausführungsform einer erfindungsgemäßen Anordnung aus der Scheibenzelle und Einspannmitteln;
- Fig. 3: eine zu den Figuren 1 und 2 gehörige Detailansicht.

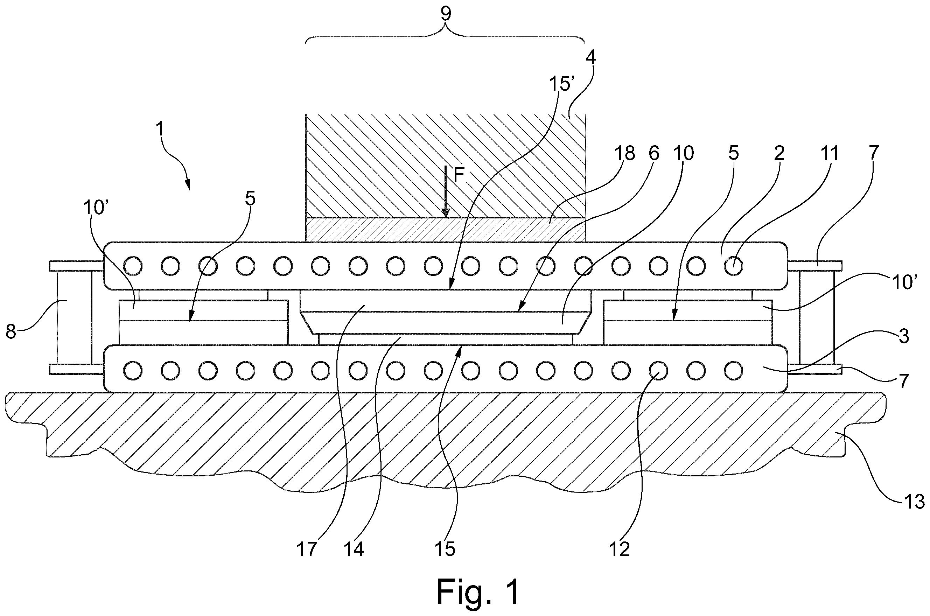

In Figur 1 ist im Schnitt und schematisch eine erfindungsgemäße erste Anordnung aus einer Scheibenzelle 1 und Einspannmitteln 4, 13 gezeigt. Die Scheibenzelle 1 weist ein hermetisch verschlossenes Gehäuse 2, 3, 7, 8 auf. Das Gehäuse 2, 3, 7, 8 umfasst einen elektrisch isolierenden Ring 8 aus Keramik, der an seinen Stirnflächen mit einer metallischen Beschichtung versehen ist. Mittels der Beschichtung ist der Ring an beiden Stirnseiten jeweils mit einer Ringscheibe 7 aus Kupfer verlötet. Die Ringscheiben 7 schließen jeweils hermetisch dicht mit einer Druckplatte 2 beziehungsweise einer druckaufnehmenden Gegenplatte 3 ab. Zwischen der Druckplatte 2 und der druckaufnehmenden Gegenplatte 3 ist genau ein rundes scheibenförmiges, erstes Halbleiterbauelement 6 erster Bauart und mehrere zweite Halbleiterbauelemente 5 der zweiten Bauart, hier IGBT's, eingespannt, wobei die zweiten Halbleiterbauelemente 5 gleichmäßig um den Außenumfang des ersten Halbleiterbauelements 6 verteilt angeordnet sind. Die Halbleiterbauelemente 5, 6 weisen jeweils rechtwinklig zur Einspannrichtung verlaufende Halbleiterschichten 10, 10' auf. Ferner sind jeweils an den mit der Druckplatte 2 und der Gegenplatte 3 in Berührkontakt stehenden Seiten der Halbeiterbauelemente 5, 6 metallische Schichten zur elektrischen Kontaktierung der Halbleiterbauelemente 5, 6 vorgesehen. Die elektrische Kontaktierung sowie eine erforderliche Wärmeabfuhr erfolgt über die Druckplatte 2 sowie die Gegenplatte 3. Zur Wärmeabfuhr sind die Druckplatte 2 und die Gegenplatte 3 mit einem oder mehreren fluidleitenden Kanälen 11, 12 durchzogen. Die Kanäle 11 der Druckplatte 2 und die Kanäle 12 der Gegenplatte 3 sind in einer rechtwinklig zur Einspannrichtung orientierten gedachten Ebene angeordnet. Die Gegenplatte 3 liegt bei der in Figur 1 gezeigten Anordnung vollflächig auf einem Kühlkörper 13 auf. Die Einspannmittel umfassen einen Druckstempel 4, 18 über den eine beispielsweise durch eine nicht dargestellte Druckschraube erzeugte Einspannkraft F auf die runde Druckplatte 2 einwirkt. Die Einwirkfläche 9 wird durch eine plateauförmige Erhebung 18 der Druckplatte 2 definiert. Die Erhebung 18 kann einstückig mit der Druckplatte 2 oder als separates Teil der Druckplatte 2 ausgebildet sein. Während das erste Halbleiterbauelement 6 unmittelbar unter dem Einwirkbereich 9 angeordnet ist, sind die zweiten Halbleiterbauelemente 5 unter dem über den Einwirkbereich hinausstehenden äußeren Teil der Druckplatte 2 angeordnet. Aufgrund der elastischen Nachgiebigkeit der Druckplatte 2 im abgezweigten Kraftverlauf durch die zweiten Halbleiterbauelemente 5 ist deren mechanische Beanspruchung gegenüber der des ersten Halbleiterbauelements 6 verringert. Weisen beispielsweise erste 6 und zweite 5 Halbleiterbauelemente keine gleichen mechanische Maximalbelastungsgrenzen auf, kann durch die erfindungsgemäße Ausgestaltung der Druckplatte 2 bis zum Erreichen der Maximalbelastung des ersten Halbleiterbauelements 6, die aus elektrischen und thermischen Kontaktierungsgründen angestrebt wird, eine mechanische Zerstörung der zweiten Halbleiterbauelemente 5 verhindert werden.

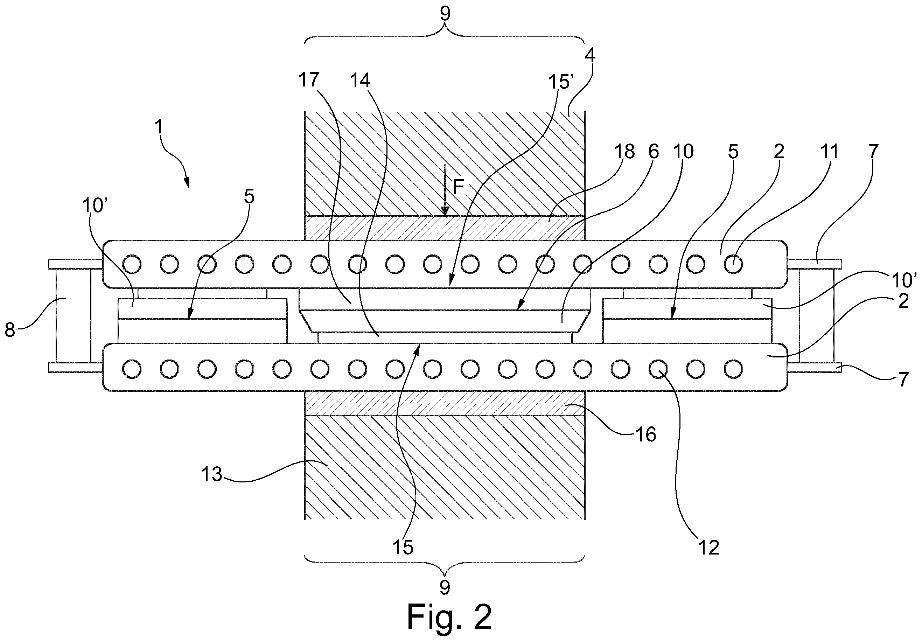

In der Figur 2 ist eine zweite Ausführungsform der erfindungsgemäßen Anordnung gezeigt, die sich von der in Figur 1 gezeigten Anordnung durch die Ausgestaltung der Einspannmittel 4, 13 und dadurch unterscheidet, dass nicht nur lediglich genau eine erfindungsgemäße Druckplatte 2 vorgesehen ist, sondern zwei von diesen Druckplatten 2. Damit stellt sich auf beiden Seiten der Halbleiterbauelemente 5, 6 der zuvor beschriebene vorteilhafte Effekt ein.

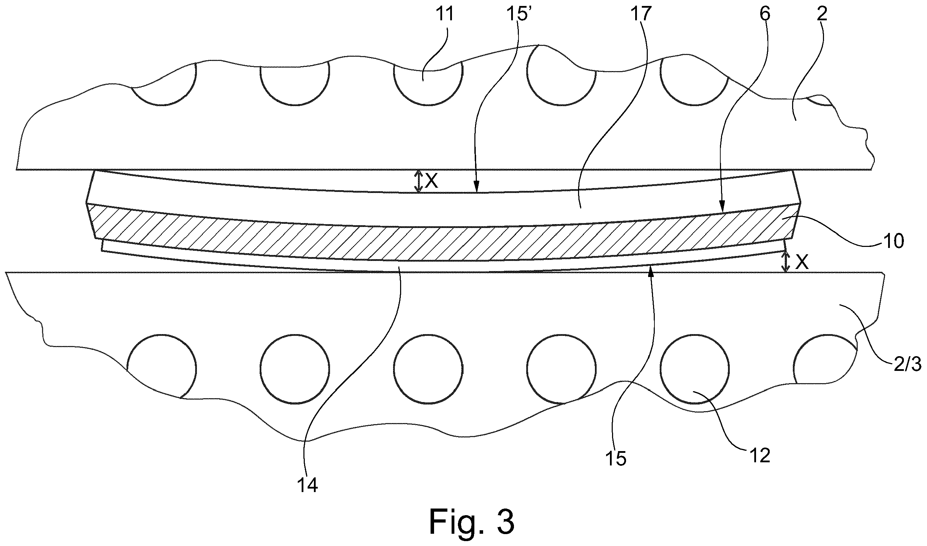

In der Figur 3 ist eine sowohl die Figur 1 als auch die Figur 2 betreffende Detailaufnahme gezeigt. Figur 3 zeigt den zwischen den Druckplatten 2 beziehungsweise zwischen der Druckplatte 2 und der Gegenplatte 3 befindlichen Schichtaufbau des ersten Halbleiterbauelements 6 im nicht eingespannten lediglich im Berührkontakt mit den Druckplatten 2 bzw. der Gegenplatte 3 befindlichen Zustand. Der gesamte Schichtaufbau des ersten Bauelements 6 ist gekrümmt, die dargestellte Krümmung ist nicht maßstäblich dargestellt. Der weg von der Halbleiterschicht 10 und hin zur metallischen Molybdänschicht 17 gekrümmte Schichtaufbau sorgt für eine "Wölbung/Überhöhung" des Halbleiterbauelements 6 um das Maß X auf beiden Seiten des ersten Bauelements 6 im Bereich der Anlageflächen 15 und 15'. Mit zunehmender Einspannung kommt es somit zum Verbiegen des Schichtaufbaus des ersten Bauelements 6 entgegen dieser Vorkrümmung. Das auf der Vorkrümmung beruhende, bevorzugt elastische Biegemoment wirkt der Einspannung entgegen und vereinfacht die Einstellung und Skalierung der Einspannkraft F auf die Maximalbelastungsgrenze des ersten Halbleiterbauelements 6. Damit ist die Gefahr der mechanischen Zerstörung des zweiten Halbleiterbauelements 5 beim Einspannen minimiert.

## Patentansprüche

1. Scheibenzelle (1) zur Druckkontaktierung mehrerer Halbleiterbauelemente mittels eine Einspannkraft (F) erzeugender Einspannmittel (4, 13), aufweisend:
ein Gehäuse (2, 3, 7, 8);
wenigstens ein erstes im Gehäuse aufgenommenes Halbleiterbauelement (6) erster Bauart;
wenigstens ein zweites im Gehäuse aufgenommenes Halbleiterbauelement (5) zweiter, zur ersten unterschiedlichen Bauart;
wobei das Gehäuse (2, 3, 7, 8) wenigstens eine das erste (6) und zweite (5) Halbleiterbauelement übergreifende, im Wesentlichen rechtwinklig zur Einspannkraft (F) ausgerichtete, metallische Druckplatte (2) zur Einspannung des ersten und zweiten Halbleiterbauelements umfasst, wobei die Druckplatte (2) ausgestaltet ist, dass die Einspannkraft (F) lokal begrenzt (9) auf diese einwirkt, um über die Druckplatte (2) das erste (6) und zweite (5) Halbleiterbauelement einzuspannen, wobei das erste Halbleiterbauelement (6) unterhalb des lokalen Einwirkbereichs (9) der Einspannkraft (F) angeordnet ist und das zweite Bauelement (5) wenigstens teilweise außerhalb des lokalen Einwirkbereichs (9) angeordnet ist.

2. Scheibenzelle (1) für mehrere Halbleiterbauelemente gemäß Anspruch 1, wobei das erste Halbleiterbauelement (6) wenigstens mit einer seiner Anlageflächen (15, 15') wenigstens im nicht eingespannten Zustand an einer zugehörigen Gegenfläche, beispielsweise der Druckplatte (2), nicht vollflächig aufliegt.

3. Scheibenzelle (1) für mehrere Halbleiterbauelemente gemäß dem vorhergehenden Anspruch, wobei das erste Halbleiterbauelement (6) im nicht eingespannten Zustand gekrümmt ausgebildet ist.

4. Scheibenzelle (1) für mehrere Halbleiterbauelemente gemäß einem der beiden vorhergehenden Ansprüche, wobei der maximale lichte Abstand zwischen der Anlagefläche und der zugehörigen Gegenfläche im nicht eingespannten Zustand in einem Bereich von 5 µm bis 150µm, bevorzugt 10µm bis 100µm liegt.

5. Scheibenzelle (1) für mehrere Halbleiterbauelemente gemäß einem der vorhergehenden Ansprüche, wobei die Anlagefläche (15, 15') durch eine Schicht (10) aus Halbleitermaterial des ersten Halbleiterbauelements (6) definiert ist.

6. Scheibenzelle (1) für mehrere Halbleiterbauelemente gemäß einem der vorhergehenden Ansprüche, wobei der lokal begrenzte Einwirkbereich (9) der Einspannkraft auf die Druckplatte (2) durch eine Erhebung (18) auf der dem Halbleiterbauelementen (5, 6) abgewandten Seite der Druckplatte (2) definiert ist.

7. Scheibenzelle (1) für mehrere Halbleiterbauelemente gemäß einem der vorhergehenden Ansprüche, wobei der Umfang des ersten Halbleiterbauelements (6) außerhalb des Einwirkbereichs (9) der Einspannkraft liegt oder deckungsgleich damit ist.

8. Scheibenzelle (1) für mehrere Halbleiterbauelemente gemäß einem der vorhergehenden Ansprüche, wobei die Druckplatte (2) rund ausgebildet ist.

9. Scheibenzelle (1) für mehrere Halbleiterbauelemente gemäß einem der vorhergehenden Ansprüche, wobei wenigstens das erste Halbleiterbauelement (6) unmittelbar angrenzend an die Druckplatte (2) angeordnet ist.

10. Scheibenzelle (1) für mehrere Halbleiterbauelemente gemäß einem der vorhergehenden Ansprüche, wobei wenigstens ein Kanal (11) für eine Fluidkühlung in die Druckplatte (2) integriert ist.

11. Scheibenzelle (1) für mehrere Halbleiterbauelemente gemäß einem der vorhergehenden Ansprüche, wobei genau ein erstes Halbleiterbauelement (6) vorgesehen ist und mehrere zweite Halbleiterbauelemente (5) vorgesehen sind, wobei die zweiten Halbleiterbauelemente (5) in einem oder verschiedenen Abständen um das erste Halbleiterbauelement (6) verteilt angeordnet sind.

12. Scheibenzelle (1) für mehrere Halbleiterbauelemente gemäß einem der vorhergehenden Ansprüche, wobei das erste Halbleiterbauelement (6) als kreisrundes Flächengebilde ausgebildet ist und mehrere zweite Halbleiterbauelemente (5) vorgesehen sind, die gleichmäßig entlang eines oder mehrerer konzentrischer Kreise um den Radialumfang des ersten Halbleiterbauelements (6) verteilt angeordnet sind.

13. Scheibenzelle (1) für mehrere Halbleiterbauelemente gemäß einem der vorhergehenden Ansprüche, wobei das wenigstens eine, zweite Halbleiterbauelement (5) als rechteckiges, bevorzugt quadratisches, rundes oder trapezförmiges Flächengebilde ausgebildet ist.

14. Scheibenzelle (1) für mehrere Halbleiterbauelemente gemäß einem der vorhergehenden Ansprüche, wobei das erste Halbleiterbauelement (6) ein monolithisches Halbleiterbauelement, wie eine Diode oder Thyristor ist.

15. Scheibenzelle (5) für mehrere Halbleiterbauelemente gemäß einem der vorhergehenden Ansprüche, wobei das wenigstens eine zweite Halbleiterbauelement (5) ein Bipolartransistor mit isolierter Gate-Elektrode ist.

16. Scheibenzelle (1) für mehrere Halbleiterbauelemente gemäß einem der vorhergehenden Ansprüche, mit zwei Druckplatten (2), wobei die Halbleiterbauelemente (5, 6) zwischen den Druckplatten (2) eingespannt sind.

17. Anordnung aus Einspannmitteln (4, 13) und einer Scheibenzelle (1) gemäß einem der vorhergehenden Ansprüche.

## Claims

1. A disc shaped casing (1) for a plurality of pressure-contacted semiconductor components by way of clamping means (4, 13) producing a clamping force (F), comprising:
a housing (2, 3, 7, 8);
at least a first semiconductor component (6) of a first construction type accommodated in a housing;
at least a second semiconductor component (5) of a second construction type different from first one, accommodated in a housing;
wherein the housing (2, 3, 7, 8) comprises at least a metal pressure plate (2) protruding the first (6) and second (5) semiconductor component and oriented essentially orthogonally to the clamping force (F), for clamping the first and second semiconductor component, wherein the pressure plate (2) is configured such that the clamping force (F) acts thereon in a locally limited manner (9), so that the first (6) and second (5) semiconductor component are clamped by way of the pressure plate (2), wherein the first semiconductor component (6) is arranged below the local zone of action (9) for the clamping force (F), and the second component (5) is arranged at least partially exterior of the local action (9).

2. The disc shaped casing (1) for a plurality of semiconductor components according to Claim 1, wherein the first semiconductor component (6), at least with its bearing surface (15, 15'), at least in the non-clamped state, does not abut the associated counter-surface with its full surface, for example the pressure plate (2).

3. The disc shaped casing (1) for a plurality of semiconductor components according to the preceding Claim, wherein the first semiconductor component (6), in the non-clamped state, is formed in a curved manner.

4. The disc shaped casing (1) for a plurality of semiconductor components according to one of the preceding Claims, wherein the maximum clearance between the bearing surface and the associated counter-surface in the non-clamped state is in the range of 5 pm to 150 pm, preferably 10pm to 100pm.

5. The disc shaped casing (1) for a plurality of semiconductor components according to one of the preceding Claims, wherein the bearing surface (15, 15') is defined by a layer (10) of semiconductor material of the first semiconductor component (6).

6. The disc shaped casing (1) for a plurality of semiconductor components according to one of the preceding Claims, wherein the locally limited action zone (9) of the clamping force on the pressure plate (2) is defined by a protrusion (18) at the side of pressure plate (2) facing away from the semiconductor component (5, 6).

7. The disc shaped casing (1) for a plurality of semiconductor components according to one of the preceding Claims, wherein the circumference of the first semiconductor component (6) is exterior of the action zone (9) of the clamping force or is superimposable thereto.

8. The disc shaped casing (1) for a plurality of semiconductor components according to one of the preceding Claims, wherein the pressure plate (2) is circularly formed.

9. The disc shaped casing (1) for a plurality of semiconductor components according to one of the preceding Claims, wherein at least the first semiconductor component (6) is arranged immediately adjacent to the pressure plate (2).

10. The disc shaped casing (1) for a plurality of semiconductor components according to one of the preceding Claims, wherein at least one channel (11) for a refrigeration fluid is incorporated into the pressure plate (2).

11. The disc shaped casing (1) for a plurality of semiconductor components according to one of the preceding Claims, wherein exactly one first semiconductor component (6) is provided, and a plurality of second semiconductor components (5) are provided, wherein the second semiconductor components (5) are arranged distributed in one or more distances around the first semiconductor component (6).

12. The disc shaped casing (1) for a plurality of semiconductor components according to one of the preceding Claims, wherein the first semiconductor component (6) is formed as a perfectly circular fabric and a plurality of second semiconductor components (5) are provided, which are arranged uniformly distributed along one or more concentric circles around the radial circumference of the first semiconductor component (6).

13. The disc shaped casing (1) for a plurality of semiconductor components according to one of the preceding Claims, wherein the at least one, second semiconductor component (5) is formed as a rectangular, preferably squared, round, or trapezoidal fabric.

14. The disc shaped casing (1) for a plurality of semiconductor components according to one of the preceding Claims, wherein the first semiconductor component (6) is a monolithic semiconductor component, such as a diode or a thyristor.

15. The disc shaped casing (5) for a plurality of semiconductor components according to one of the preceding Claims, wherein the at least second semiconductor component (5) is a bipolar transistor with an isolated gate electrode.

16. The disc shaped casing (1) for a plurality of semiconductor components according to one of the preceding Claims, having two pressure plates (2), wherein the semiconductor components (5, 6) are clamped between the pressure plates (2).

17. An assembly of clamping means (4, 13) and a disc shaped casing (1) according to one of the preceding Claims.

## Revendications

1. Boitier circulaire (1) pour contact à pression d'une pluralité de composants semi-conducteurs par voie de moyens de serrage (4, 13) produisant une force de serrage (F) comprenant :
un carter (2, 3, 7, 8) ;
au moins un premier composant semi-conducteur (6) d'un premier type de construction accommodé dans un carter ;
au moins un seconde composant semi-conducteur (5) d'une seconde type de construction différent de la premier, accommodé dans un carter ;
dans lequel le carter (2, 3, 7, 8) comprend au moins une plaque de pression (2) métallique débordant la premier (6) et seconde (5) composant semi-conducteur et orientée sensiblement orthogonal à la force de serrage (F), pour le serrage du premier et seconde composant semi-conducteur, dans lequel la plaque de pression (2) est configurée tel que la force de serrage (F) agit sur ceux-ci localement limitée (9), pour que le premier (6) et seconde (5) composant semi-conducteur soient serrés par voie de la plaque de pression (2), dans lequel le premier composant semi-conducteur (6) est disposé au-dessous de la zone d'action (9) locale de la force de serrage (F) et le seconde composant (5) est dispose au moins partiellement à l'extérieure de la zone d'action (9) locale.

2. Boitier circulaire (1) pour une pluralité de composants semi-conducteurs selon la revendication 1, dans lequel le premier composant semi-conducteur (6), au moins avec sa face d'appui (15, 15'), au moins en état non serré, ne vient pas en appui par toute sa surface à une contre-face associée, par exemple la plaque de pression (2).

3. Boitier circulaire (1) pour une pluralité de composants semi-conducteurs selon la revendication précédente, dans lequel le premier composant semi-conducteur (6), en état non-serré, est agencé d'une façon courbée.

4. Boitier circulaire (1) pour une pluralité de composants semi-conducteurs selon l'une des revendications précédentes, dans lequel la distance libre maximale entre la face d'appui et la contre-face associée en état non-serré est dans la plage de 5pm à 150pm, préférentiellement 10pm à 100pm

5. Boitier circulaire (1) pour une pluralité de composants semi-conducteurs selon l'une des revendications précédentes, dans lequel la face d'appui (15, 15') est définie par une couche (10) de matériau semiconducteur du premier composant semi-conducteur (6).

6. Boitier circulaire (1) pour une pluralité de composants semi-conducteurs selon l'une des revendications précédentes, dans lequel la zone d'action (9) localement limitée de la force de serrage sur la plaque de pression (2) est définie par un bossage (18) sur le côté de la plaque de pression (2) détourné du composant semi-conducteur (5, 6).

7. Boitier circulaire (1) pour une pluralité de composants semi-conducteurs selon l'une des revendications précédentes, dans lequel la circonférence du premier composant semi-conducteur (6) est à l'extérieure de la zone d'action (9) de la force de serrage ou est en coïncidence de celle-ci.

8. Boitier circulaire (1) pour une pluralité de composants semi-conducteurs selon l'une des revendications précédentes, dans lequel la plaque de pression (2) est formée arrondie.

9. Boitier circulaire (1) pour une pluralité de composants semi-conducteurs selon l'une des revendications précédentes, dans lequel au moins le premier composant semi-conducteur (6) est disposé immédiatement adjacent à la plaque de pression (2).

10. Boitier circulaire (1) pour une pluralité de composants semi-conducteurs selon l'une des revendications précédentes, dans lequel au moins un canal (11) pour une réfrigération de fluide est intégré dans la plaque de pression (2).

11. Boitier circulaire (1) pour une pluralité de composants semi-conducteurs selon l'une des revendications précédentes, dans lequel exactement un premier composant semi-conducteur (6) est prévu et une pluralité de seconde composants semi-conducteurs (5) sont prévus, dans lesquelles secondes composants semi-conducteurs (5) sont disposés de manière répartie à un ou plusieurs distances autour du premier composant semi-conducteur (6).

12. circulaire (1) pour une pluralité de composants semi-conducteurs selon l'une des revendications précédentes, dans lequel le premier composant semi-conducteur (6) est agencé en tant que textile circulaire et une pluralité de secondes composants semi-conducteurs (5) sont prévus, qui sont disposés de manière répartie uniformément le long 'un ou plusieurs cercles concentriques autour de la circonférence radiale du premier composant semi-conducteur (6).

13. Boitier circulaire (1) pour une pluralité de composants semi-conducteurs selon l'une des revendications précédentes, dans lequel ledit au moins un, seconde composant semi-conducteur (5) est agencé en tant que textile rectangulaire, préférentiellement quadratique, ronde, ou trapézoïdal.

14. Boitier circulaire (1) pour une pluralité de composants semi-conducteurs selon l'une des revendications précédentes, dans lequel le premier composant semi-conducteur (6) est un composant semi-conducteur monolithique, comme une diode ou un thyristor.

15. Boitier circulaire (5) pour une pluralité de composants semi-conducteurs selon l'une des revendications précédentes, dans lequel ledit au moins seconde composant semi-conducteur (5) est un transistor bipolaire avec électrode de grille isolée.

16. Boitier circulaire (1) pour une pluralité de composants semi-conducteurs selon l'une des revendications précédentes, ayant deux plaques de pression (2), dans lequel les composants semi-conducteurs (5, 6) sont serrés dans les plaques de pression (2).

17. Disposition de moyens de serrage (4, 13) et d'un boitier circulaire (1) selon l'une des revendications précédentes.
